# FASCICULE DE BREVET EUROPEEN

(11) **EP 0 709 891 B1**
(45) Date de publication et mention de la délivrance du brevet: **30.08.2000**
(21) Numéro de dépôt: 95410123.4
(22) Date de dépôt: 24.10.1995
(51) Int. Cl.: H01L 27/07, H01L 29/74

(54) **Thyristor commandable par des niveaux logiques**
Über logische Niveaus ansteuerbarer Thyristor
Logic level controllable thyristor

(30) Priorité: 28.10.1994 FR 9413147
(43) Date de publication de la demande: 01.05.1996
(73) Titulaire: STMicroelectronics S.A., 94250 Gentilly (FR)
(72) Inventeur: Pezzani, Robert, F-37210 Vouvray (FR)
(74) Mandataire: de Beaumont, Michel

(56) Documents cités:
- EP-A- 0 011 443
- EP-A- 0 214 027
- EP-A- 0 599 739
- DE-A- 3 810 536
- FR-A- 2 234 662
- GB-A- 2 069 255
- PATENT ABSTRACTS OF JAPAN vol. 6 no. 155 (E-125) ,17 Août 1982 & JP-A-57 075599 (NIPPON DENSO CO LTD) 12 Mai 1982,

## Description

La présente invention concerne un thyristor destiné à être commandé directement par des signaux logiques fournis par un microcontrôleur et incorporant un circuit translateur de niveau de tension de gâchette. Elle s'applique en particulier à des circuits de chargeurs de batterie régulés dans lesquels la régulation est assurée au secondaire d'un transformateur.

Ainsi, l'invention s'applique à des configurations dans lesquelles un circuit de chargeur est incorporé entre les bornes du secondaire d'un transformateur et une borne de charge de batterie, l'autre borne de la batterie étant connectée à la masse. Des exemples de tels circuits sont connus dans la technique. Ils comprennent de façon générale un commutateur de puissance commandé en découpage pour fournir un courant moyen constant à la batterie. Ils comprennent également un circuit intégré de commande ou microcontrôleur, par exemple le circuit commercialisé sous la référence ST62 par SGS-Thomson, et un circuit intégré de régulation de tension propre à fournir une alimentation régulée de valeur déterminée, par exemple +5 volts, notamment pour le circuit de commande. Le microcontrôleur reçoit des informations sur le courant dans la batterie, par exemple en détectant la tension aux bornes d'une résistance disposée en série avec la batterie.

En pratique, de tels circuits de chargeurs de batterie comprennent donc deux circuits intégrés, le microcontrôleur et le circuit de régulation de tension, et un certain nombre de composants discrets correspondant notamment à un ou plusieurs commutateurs de puissance, à des circuits d'adaptation du signal de commande et à des redresseurs destinés à être connectés au commutateur de puissance et à la borne d'alimentation du circuit de régulation de tension.

D'autres circuits sont décrits dans JP-A-57 075599 et EP-A-11443.

La présente invention s'intéresse plus particulièrement au cas où le ou les commutateurs de puissance sont des commutateurs de type thyristor. Une étude des circuits à thyristors existants a montré que l'ensemble des composants discrets associés aux thyristors et à la fonction de redressement n'était pas réalisable sous forme d'un composant monolithique.

Un objet de la présente invention est de prévoir un composant monolithique constituant un thyristor et des éléments d'adaptation d'un signal logique de commande.

Un autre objet de la présente invention est de prévoir un tel composant monolithique incorporant en outre des éléments de redressement.

Un autre objet de la présente invention est de prévoir un circuit à découpage de chargeur de batterie comprenant seulement trois composants : un premier composant rassemblant toutes les fonctions de puissance, un deuxième composant constituant un microcontrôleur connu en lui-même et un troisième composant constituant un circuit de régulation de tension connu en lui-même.

Pour atteindre ces objets, la demanderesse a conçu une nouvelle configuration de circuit comprenant un thyristor telle que revendiquée dans la revendication 1, une nouvelle configuration de circuit de chargeur et un composant monolithique incorporant tous les composants de puissance de ce circuit.

Plus particulièrement, la présente invention prévoit un thyristor commandable par des niveaux logiques quelle que soit sa tension de cathode, comprenant un thyristor, un transistor PNP entre gâchette et anode du thyristor, et un transistor NPN entre la base du transistor PNP et une borne reliée à la masse par l'intermédiaire d'une résistance, la base du transistor NPN recevant lesdits signaux logiques.

La présente invention prévoit aussi un circuit à découpage de chargeur de batterie disposé au secondaire d'un transformateur pour charger une batterie dans des conditions fixées par un circuit intégré de commande de découpage, comprenant le thyristor susmentionné et des diodes redresseuses connectées entre les bornes du secondaire du transformateur et l'anode du thyristor.

Ce circuit peut aussi comprendre une borne propre à alimenter un circuit de fourniture de tension régulée, et une diode connectée entre le point commun des première et deuxième diodes et ladite borne.

Selon un mode de réalisation de la présente invention, le thyristor susmentionné comprend, dans un substrat d'un premier type de conductivité à faible niveau de dopage, un thyristor à caisson comprenant du côté de la face inférieure du substrat, une première région du deuxième type de conductivité, un mur d'isolement du deuxième type de conductivité s'étendant de la surface supérieure du substrat à la périphérie de la première région, du côté de la face supérieure du substrat, une deuxième région du deuxième type de conductivité et une troisième région du premier type de conductivité formée dans la troisième région ; dans une portion de la région du substrat délimitée par le mur d'isolement, une quatrième région du deuxième type de conductivité et, dans cette quatrième région, une cinquième région du premier type de conductivité ; et des première à quatrième métallisations respectivement en contact avec la face arrière du substrat, la troisième région, la quatrième région et la cinquième région.

La présente invention prévoit aussi un circuit à découpage de chargeur de batterie disposé au secondaire d'un transformateur pour charger une batterie dans des conditions fixées par un circuit intégré de commande de découpage, comprenant un premier et un deuxième thyristor tels que susmentionné entre chacune des bornes du transformateur et une borne d'alimentation de la batterie, et des diodes redresseuses entre chacune des bornes du transformateur et une borne d'alimentation commune.

Selon un mode de réalisation de la présente invention, le thyristor susmentionné comprend, dans un substrat d'un premier type de conductivité à faible niveau de dopage, une première couche du deuxième type de conductivité, du côté de la face arrière du substrat, un mur d'isolement du deuxième type de conductivité s'étendant de la face supérieure du substrat à la périphérie de la première couche, du côté de la face supérieure du substrat, des deuxièmes régions et des troisièmes régions du deuxième type de conductivité, des quatrièmes régions du premier type de conductivité formées dans les troisièmes régions, une cinquième région du deuxième type de conductivité formée du côté de la face arrière du substrat, des premières métallisations solidaires de chacune des deuxièmes régions, une deuxième métallisation solidaire des troisièmes régions, une troisième métallisation solidaire des quatrièmes régions, et une quatrième métallisation solidaire de la face arrière.

Ces objets, caractéristiques et avantages ainsi que d'autres de la présente invention seront exposés en détail dans la description suivante de modes de réalisation particuliers faite à titre non-limitatif en relation avec les figures jointes parmi lesquelles :
la figure 1 représente un circuit de chargeur de batterie à découpage selon la présente invention ;
la figure 2 représente une variante du transformateur de la figure 1 ;
la figure 3 représente schématiquement une vue en coupe d'un composant monolithique incorporant les éléments de puissance du circuit de chargeur à découpage selon l'invention ;
la figure 4 représente une variante du circuit de chargeur de batterie à découpage selon l'invention ; et
les figures 5A et 5B représentent schématiquement une vue en coupe et une vue de dessus d'un composant monolithique incorporant les éléments du circuit de la figure 4.

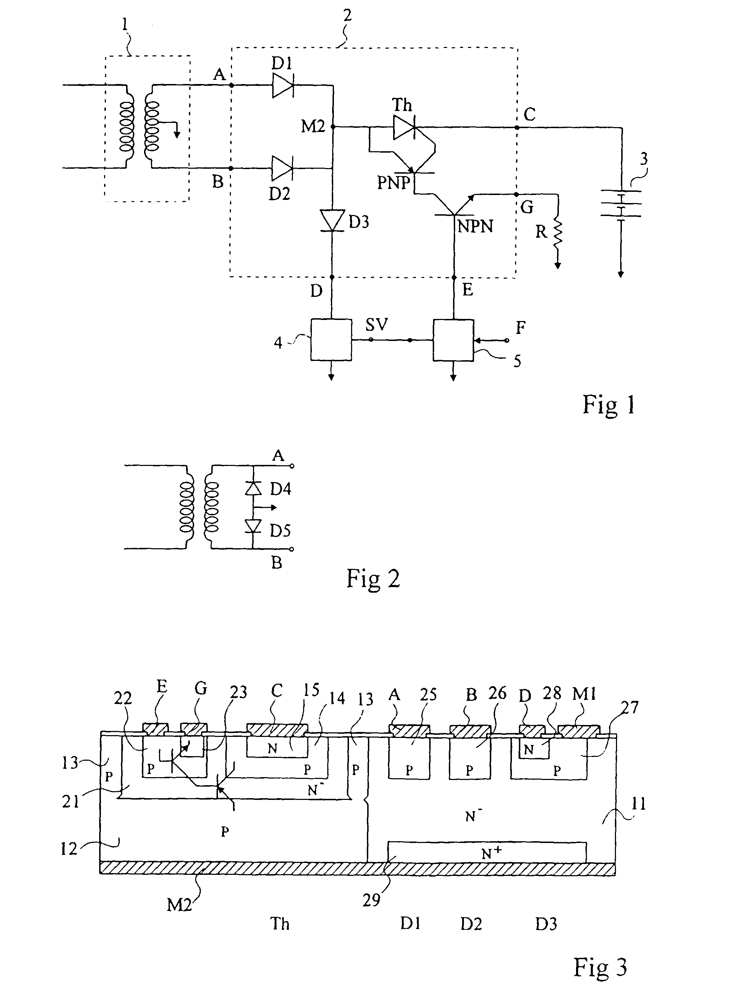

Comme le représente la figure 1, un circuit de chargeur de batterie à découpage, connecté au secondaire d'un transformateur 1 à point milieu relié à la masse, comprend de façon générale divers composants constituant un circuit de puissance 2, une batterie à charger 3, un circuit de fourniture de tension régulée 4 et un microcontrôleur 5.

Le circuit de puissance 2 comporte des bornes d'entrée A et B reliées au secondaire du transformateur 1, une borne C d'alimentation de la batterie 3, une borne D d'alimentation en tension continue du circuit 4 de fourniture de tension régulée, et une borne E de réception du signal de commande fourni par le circuit 5.

De nombreuses réalisations du circuit 4 et du microcontrôleur 5 sont connues dans la technique. Classiquement, le circuit de fourniture de tension régulée 4 fournit une tension régulée de 5 volts destinée à alimenter le microcontrôleur 5. Ce microcontrôleur 5, en plus de son entrée d'alimentation, comprend une entrée de régulation F qui correspond par exemple à une prise de tension sur une résistance en série avec la batterie 3. Le microcontrôleur 5 fournit sur la borne E des signaux logiques de commande qui présentent un niveau bas correspondant au niveau de la masse et un niveau haut d'environ 5 V par rapport à la masse. Ces signaux logiques ne permettent pas de commander directement la gâchette d'un thyristor dont la cathode n'est pas à la masse, et qui est par exemple au potentiel élevé d'une batterie. Il faut alors prévoir un circuit d'adaptation des signaux logiques de commande ou circuit translateur de niveau.

Le circuit 2 selon l'invention comprend des éléments de redressement destinés à fournir la tension redressée du secondaire du transformateur, d'une part, à l'anode d'un commutateur de puissance, d'autre part, à la borne D. Dans le mode de réalisation représenté, ces éléments de redressement comprennent des diodes D1, D2, D3. Les anodes des diodes D1 et D2 sont connectées aux deux bornes du secondaire du transformateur, et les cathodes des diodes D1 et D2 sont connectées à l'anode d'un thyristor Th et à l'anode de la diode D3. La diode D3 est destinée à éviter un retour de la tension sur la borne D vers l'anode du thyristor Th lors des passages à basse tension de la tension au secondaire du transformateur.

Le circuit d'adaptation des signaux de commande arrivant sur la borne E est constitué d'un transistor PNP connecté entre anode et gâchette du thyristor Th et d'un transistor NPN connecté entre la base du transistor PNP et une borne G reliée à la masse par l'intermédiaire d'une résistance de limitation de courant R. Les signaux de commande sur la borne E sont appliqués à la base du transistor NPN. Ainsi, en présence de signaux positifs sur la borne E, les transistors NPN et PNP deviennent passants et l'anode du thyristor est reliée à sa gâchette, ce qui rend le thyristor passant dès que la tension sur son anode est suffisamment supérieure à la tension sur sa cathode.

Ce circuit d'adaptation et son mode de réalisation sous forme de composant monolithique constituent un aspect de la présente invention.

La figure 2 représente une variante de réalisation dans laquelle le transformateur 1 n'est pas un transformateur dont le secondaire comporte un point milieu qui peut être relié à la masse. Dans ce cas, les bornes A et B sont reliées à la masse par des diodes respectives D4 et D5 dont les anodes sont à la masse.

La figure 3 représente de façon très schématique une vue en coupe d'un composant semiconducteur incorporant les éléments du circuit 2 de la figure 1. Il sera clair pour l'homme de l'art que ce schéma n'est à l'échelle ni dans la dimension verticale ni dans la dimension horizontale. En particulier, les surfaces des divers éléments seront choisies en fonction des courants maximum susceptibles de les traverser. En ce qui concerne les niveaux de dopage et les profondeurs de jonction, on se référera aux connaissances générales de l'homme du métier dans le domaine.

Le composant de la figure 3 est construit à partir d'un substrat 11 de silicium monocristallin de type N faiblement dopé. Dans la partie gauche de la figure est représenté un thyristor à caisson, c'est-à-dire un thyristor dans lequel une couche 12 de type P est formée à partir de la surface inférieure du substrat et est rejointe à sa périphérie par un mur d'isolement 13 de type P formé à partir de la surface supérieure. Ce thyristor, qui constitue le thyristor Th de la figure 1, comprend la couche 12 susmentionnée, correspondant à son anode, une portion 21 du substrat et, du côté de la surface supérieure, une première région 14 de type P dans laquelle est formée une région 15 de type N constituant la cathode.

Dans la partie 21 du substrat 11 délimitée par le mur d'isolement 13 est formée une deuxième région 22 de type P dans laquelle est formée une région 23 de type N.

La région 22 est revêtue d'une métallisation E, la région 23 d'une métallisation G, la région 15 d'une métallisation C, et la face arrière du substrat d'une métallisation M2. Ces métallisations correspondent aux bornes de même nom en figure 1. La métallisation M2 correspond à l'anode du thyristor Th.

Ainsi, à l'intérieur du caisson délimité par les murs d'isolement 13, on retrouve le thyristor Th comprenant les couches 12-21-14-15 entre les bornes M2 et C. Le transistor PNP connecté entre anode et gâchette du thyristor Th correspond à une partie de ce thyristor et plus particulièrement aux couches 12-21-14. Le transistor NPN a un émetteur qui correspond à la région 23 reliée à la borne G, une base qui correspond à la région 22 reliée à la borne E et un collecteur qui correspond à la couche 21, c'est-à-dire à la région de base du transistor PNP.

En dehors de la région délimitée par le mur d'isolement 13 sont formées à partir de la surface supérieure du substrat trois régions de type P 25, 26 et 27, une région 28 de type N étant formée à l'intérieur de la région 27. A partir de la surface inférieure du substrat 11, sous les régions 25, 26 et 27, est de préférence formée une région de type N fortement dopée 29.

La région 25 est recouverte d'une métallisation A, la région 26 d'une métallisation B, la région 28 d'une métallisation D, la région 27 d'une métallisation M1 qui la met en court-circuit avec une portion, de préférence surdopée, de la surface supérieure du substrat 11. Ces métallisations correspondent aux bornes désignées par les mêmes références en figure 1. Ainsi, on retrouve :
- entre les métallisations A et M2, une diode verticale 25-11-29 correspondant à la diode D1,
- entre les métallisations B et M2, une diode verticale 26-11-29 correspondant à la diode D2,
- entre les métallisations D et M1, une diode latérale constituée par la jonction entre les régions 28 et 27 correspondant à la diode D3. L'anode de cette diode qui correspond à la métallisation M1 est reliée à la métallisation M2 par le trajet conducteur s'étendant à travers le substrat 11 et la couche 29. On notera que cette diode présente une résistance série plus forte que les diodes D1 et D2 mais ceci ne constitue pas un inconvénient en pratique puisque la diode D3 n'est pas destinée à laisser passer un courant important comme les diodes D1 et D2 mais seulement à servir d'alimentation au circuit 4 de fourniture de tension régulée.

On a donc bien obtenu le circuit de la figure 1, sous forme monolithique.

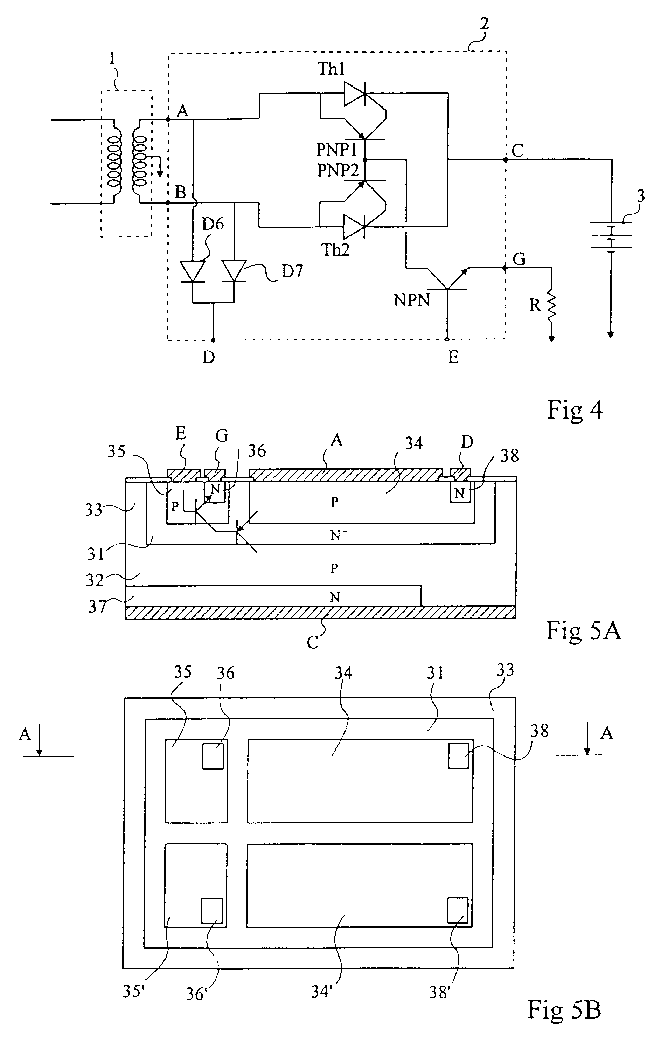

La figure 4 représente une variante du circuit de chargeur 2 illustré en figure 1.

Dans cette variante, un premier thyristor Th1 est disposé entre les bornes A et C et un deuxième thyristor Th2 est disposé entre les bornes B et C. Des diodes D6 et D7 sont connectées entre chacune des bornes A et B et la borne D. A chacun des thyristors Th1 et Th2 est associé un transistor PNP1, PNP2, de la même façon que le transistor PNP au thyristor Th de la figure 1. Un transistor NPN est relié entre les bases communes des transistors PNP1 et PNP2 et la borne G. La base de ce transistor NPN est connectée à la borne E. Ainsi, on retrouve pour chacun des thyristors Th1 et Th2 un circuit d'adaptation des signaux logiques de commande appliqués sur la borne E identique à celui illustré en figure 1.

Un avantage du circuit de la figure 4 par rapport au circuit de la figure 1 est que les pertes sont réduites car l'alimentation de la batterie se fait uniquement par l'intermédiaire d'un thyristor alors que, dans le cas du circuit de la figure 1, elle se fait par la connexion en série d'une diode et d'un thyristor.

Comme on le verra ci-après en relation avec les figures 5A et 5B, le circuit de la figure 4 se prête à une intégration particulièrement simple.

La figure 5A représente une vue en coupe schématique d'un composant mettant en oeuvre l'ensemble des éléments contenus dans le circuit 2 de la figure 4. Ce composant est constitué à partir d'un substrat 31 de type N faible dopé. Une couche P 32 est formée à partir de la surface inférieure du substrat et un anneau périphérique de type P 33 est formé à partir de la surface supérieure. En outre, à partir de la surface supérieure sont formées une première région 34 de type P et une deuxième région 35 de type P. Dans la région 35, est formée une région 36 de type N. Les régions 34, 35, 36 sont respectivement revêtues de métallisations A, E, et G. Sous l'ensemble de la région 35 et la plus grande partie de la région 34 est formée à partir de la face inférieure une région 37 de type N.

On obtient ainsi une structure rassemblant comme celle de la partie gauche de la figure 3 un thyristor, un transistor PNP connecté entre son anode et sa gâchette et un transistor NPN connecté entre la base du transistor PNP et une borne extérieure. Le thyristor est constitué des régions 34, 31, 32 et 37, la région 34 correspondant à son anode et la région 37 à sa cathode. Le transistor PNP correspond aux régions 34, 31 et 32, la région 34 correspondant à son émetteur. Le transistor NPN correspond aux régions 36, 35 et 31, la région 36 correspondant à son émetteur. Cet ensemble correspond bien à un thyristor associé à un circuit translateur de niveau. En effet, si une tension référencée à la masse est appliquée à la borne E, elle provoque la mise en conduction du transistor PNP et par conséquent l'amorçage du thyristor. On notera que, par rapport à la représentation de la figure 3, en figure 5A, la face inférieure est revêtue d'une métallisation C qui constitue la cathode du thyristor et est connectée à la borne C alors que, en figure 3, la métallisation de face inférieure M2 n'était pas reliée à une borne externe.

En outre, la présente invention prévoit d'insérer dans la région 34 d'anode du thyristor une région 38 de type N reliée à une métallisation D, la diode D6 (ou D7) étant constituée de la jonction entre les régions 34 et 38.

La figure 5A est une vue en coupe selon la ligne A-A de la figure 5B. Dans cette figure 5B, de mêmes références qu'en figure 5A désignent de mêmes régions. Des références primées désignent les éléments de la deuxième moitié de la structure. En figure 5B, les métallisations n'ont pas été représentées pour simplifier la figure. La région 34' est solidaire de la borne B, la région 35' comme la région 35 est reliée à la borne E, la région 36' comme la région 36 est reliée à la borne G et la région 38' comme la région 38 est reliée à la borne D.

Dans le cas où l'on utilise un transformateur sans point milieu, le composant selon l'invention pourra être connecté aux bornes A et B de la figure 2.

## Revendications

1. Circuit comprenant un thyristor commandable par des niveaux logiques référencés à la masse quelle que soit sa tension de cathode, caractérisé en ce qu'il comprend :
un thyristor (Th) ;
un transistor PNP connecté entre la gâchette de cathode et l'anode du thyristor ; et
un transistor NPN entre la base du transistor PNP et une borne reliée à la masse par l'intermédiaire d'une résistance, la base du transistor NPN recevant lesdits signaux logiques.

2. Circuit à découpage de chargeur de batterie disposé au secondaire d'un transformateur (1) pour charger une batterie (3) dans des conditions fixées par un circuit intégré de commande de découpage (5), caractérisé en ce qu'il comprend :
un thyristor (Th) selon la revendication 1 ; et
des diodes redresseuses (D1, D2) connectées entre les bornes du secondaire du transformateur et l'anode du thyristor.

3. Circuit à découpage de chargeur de batterie selon la revendication 2, comprenant en outre une borne propre à alimenter un circuit (4) de fourniture de tension régulée, caractérisé en ce qu'il comprend en outre une diode (D3) connectée entre le point commun des première et deuxième diodes et ladite borne.

4. Thyristor selon la revendication 1, caractérisé en ce qu'il comprend dans un substrat (11) d'un premier type de conductivité à faible niveau de dopage :
- un thyristor à caisson comprenant :
. du côté de la face inférieure du substrat, une première région (12) du deuxième type de conductivité, un mur d'isolement (13) du deuxième type de conductivité s'étendant de la surface supérieure du substrat à la périphérie de la première région (12),
. du côté de la face supérieure du substrat, une deuxième région (14) du deuxième type de conductivité et une troisième région (15) du premier type de conductivité formée dans la troisième région ;
- dans une portion de la région (21) du substrat délimitée par le mur d'isolement, une quatrième région (22) du deuxième type de conductivité et, dans cette quatrième région, une cinquième région (23) du premier type de conductivité,
- des première à quatrième métallisations (M2, C, E, G) respectivement en contact avec la face arrière du substrat, la troisième région, la quatrième région et la cinquième région.

5. Composant semiconducteur monolithique pour la mise en oeuvre du circuit selon la revendication 2, comprenant un thyristor selon la revendication 4, caractérisé en ce qu'il comprend en outre, en dehors de la région délimitée par le mur d'isolement :
une première diode verticale (D1) formée entre une cinquième métallisation (A) solidaire d'une sixième région (25) du deuxième type de conductivité et la première métallisation (M2),
une deuxième diode verticale (D2) formée entre une sixième métallisation (B) solidaire d'une septième région (26) du deuxième type de conductivité et la première métallisation (M2),
une troisième diode latérale (D3) formée entre une septième métallisation (M1), solidaire d'une huitième région (27) du deuxième type de conductivité et du substrat (11), et une huitième métallisation (D) solidaire d'une neuvième région (28) du premier type de conductivité formée dans la huitième région (27).

6. Circuit à découpage de chargeur de batterie disposé au secondaire d'un transformateur (1) pour charger une batterie dans des conditions fixées par un circuit intégré de commande à découpage (5), caractérisé en ce qu'il comprend :
un premier et un deuxième thyristor (Th) selon la revendication 1 entre chacune des bornes du transformateur et une borne d'alimentation de la batterie,
des diodes redresseuses (D6, D7) entre chacune des bornes du transformateur et une borne d'alimentation commune (D).

7. Thyristor monolithique selon la revendication 1, caractérisé en ce qu'il comprend dans un substrat (31) d'un premier conductivité à faible niveau de dopage :
une première couche (32) du deuxième type de conductivité, du côté de la face arrière du substrat,
un mur d'isolement (33) du deuxième type de conductivité s'étendant de la face supérieure du substrat à la périphérie de la première couche (32),
du côté de la face supérieure du substrat, des deuxièmes régions (34, 34') et des troisièmes régions (35, 35') du deuxième type de conductivité,
des quatrièmes régions (36, 36') du premier type de conductivité formées dans les troisièmes régions,
une cinquième région (37) du deuxième type de conductivité formée du côté de la face arrière du substrat,
des premières métallisations (A, B) solidaires de chacune des deuxièmes régions,
une deuxième métallisation (E) solidaire des troisièmes régions,
une troisième métallisation (G) solidaire des quatrièmes régions, et
une quatrième métallisation (C) solidaire de la face arrière.

8. Composant semiconducteur monolithique pour la mise en oeuvre du circuit selon la revendication 6, comprenant un thyristor selon la revendication 7, caractérisé en ce qu'il comprend en outre, dans les deuxièmes régions (34, 34'), des sixièmes régions (38, 38') solidaires d'une cinquième métallisation (D).

## Patentansprüche

1. Schaltung mit einem durch auf Masse bezogene logische Pegel steuerbaren Thyristor, unabhängig von seiner Kathodenspannung,
dadurch gekennzeichnet, daß die Schaltung umfaßt:
- einen Thyristor (Th);
- einen zwischen der Gate-Kathode und der Anode des Thyristors angeschlossenen PNP-Transistor; sowie
- einen NPN-Transistor zwischen der Basis des PNP-Transistors und einem über einen Widerstand mit Masse verbundenen Anschluß, wobei die genannten logischen Signale der Basis des NPN-Transistors zugeführt werden.

2. Batterieladeschaltung mit Anschnittsteuerung auf der Sekundärseite eines Transformators (1) zur Ladung einer Batterie (3) unter Bedingungen, welche durch eine integrierte Anschnittsteuerschaltung (5) vorgegeben werden,
dadurch gekennzeichnet, daß die Schaltung umfaßt:
- einen Thyristor (Th) nach Anspruch 1; sowie
- Gleichrichtdioden (D1, D2) zwischen den Anschlüssen der Sekundärwicklung des Transformators und der Anode des Thyristors.

3. Batterieladeschaltung mit Anschnittsteuerung nach Anspruch 2, die des weiteren einen Anschluß zur Speisung einer Schaltung (4) zur Erzeugung einer geregelten Spannung aufweist,
dadurch gekennzeichnet, daß die Schaltung des weiteren eine zwischen dem gemeinsamen Punkt der ersten und der zweiten Diode und dem genannten Anschluß liegende Diode (D3) aufweist.

4. Thyristor nach Anspruch 1,
dadurch gekennzeichnet, daß er in einem Substrat (11) eines ersten Leitfähigkeitstyps mit schwachem Dotierungspegel umfaßt:
- einen Thyristor vom Grabentyp, welcher aufweist:
. auf der Rück- bzw. Unterseite des Substrats einen ersten Bereich (12) vom zweiten Leitfähigkeitstyp, eine(n) Isolierwandung bzw. -graben (13) vom zweiten Leitfähigkeitstyp, die bzw. der sich von der Oberseite des Substrats bis zum Umfang des ersten Bereichs (12) erstreckt,
. auf der Oberseite des Substrats einen zweiten Bereich (14) vom zweiten Leitfähigkeitstyp und einen in dem zweiten Bereich ausgebildeten dritten Bereich (15) vom ersten Leitfähigkeitstyp;
- in einem durch die Isolierwandung begrenzten Teil des Bereichs (21) des Substrats einen vierten Bereich (22) vom zweiten Leitfähigkeitstyp und in diesem vierten Bereich einen fünften Bereich (23) vom ersten Leitfähigkeitstyp,
- erste bis vierte Metallisierungen (M2, C, E, G), die jeweils mit der Hinter- bzw. Unterseite des Substrats, mit dem dritten Bereich, mit dem vierten Bereich bzw. mit dem fünften Bereich in Kontakt stehen.

5. Monolithisches Halbleiterbauteil für die Realisierung der Schaltung nach Anspruch 2, mit einem Thyristor nach Anspruch 4,
dadurch gekennzeichnet, daß das Bauteil außerhalb des durch die Isolierwandung begrenzten Bereichs des weiteren umfaßt:
- eine erste vertikale Diode (D1), welche zwischen einer mit einem sechsten Bereich (25) vom zweiten Leitfähigkeitstyp verbundenen fünften Metallisierung (A) und der ersten Metallisierung (M2) ausgebildet ist,
- eine zweite vertikale Diode (D2), welche zwischen einer mit einem siebenten Bereich (26) vom zweiten Leitfähigkeitstyp verbundenen sechsten Metallisierung (B) und der ersten Metallisierung (M2) ausgebildet ist,
- eine dritte laterale Diode (D3), welche zwischen einer mit einem achten Bereich (27) vom zweiten Leitfähigkeitstyp und mit dem Substrat (11) verbundenen siebenten Metallisierung (M1) und einer mit einem in dem achten Bereich (27) ausgebildeten neunten Bereich (28) vom ersten Leitfähigkeitstyp verbundenen achten Metallisierung (D) ausgebildet ist.

6. Batterieladeschaltung mit Anschnittsteuerung, auf der Sekundärseite eines Transformators (1) zur Ladung einer Batterie unter durch eine integrierte Anschnittsteuerschaltung vorgegebenen Bedingungen,
dadurch gekennzeichnet, daß die Schaltung umfaßt:
- einen ersten und einen zweiten Thyristor (Th) nach Anspruch 1 zwischen jedem der Anschlüsse des Transformators und einem Speiseanschluß der Batterie,
- Gleichrichtdioden (D6, D7) zwischen jedem der Anschlüsse des Transformators und einem gemeinsamen Speiseanschluß (D).

7. Monolithischer Thyristor nach Anspruch 1, dadurch gekennzeichnet, daß er in einem Substrat (31) eines ersten Leitfähigkeitstyps mit niedrigem Dotierungspegel umfaßt:
- eine erste Schicht (32) vom zweiten Leitfähigkeitstyp auf der Rück- bzw. Unterseite des Substrats,
- eine Isolierwandung (33) vom zweiten Leitfähigkeitstyp, welche sich von der Oberseite des Substrats bis zum Umfang der ersten Schicht (32) erstreckt,
- auf der Oberseite des Substrats zweite Bereiche (34, 34') und dritte Bereiche (35, 35') vom zweiten Leitfähigkeitstyp,
- in den dritten Bereichen ausgebildete vierte Bereiche (36, 36') vom ersten Leitfähigkeitstyp,
- einen an der Rück- bzw. Unterseite des Substrats ausgebildeten fünften Bereich (37) vom zweiten Leitfähigkeitstyp,
- mit jedem der zweiten Bereiche verbundene erste Metallisierungen (A, B),
- eine mit den dritten Bereichen verbundene zweite Metallisierung (E),
- eine mit den vierten Bereichen verbundene dritte Metallisierung (G), und
- eine mit der Rück- bzw. Unterseite verbundene vierte Metallisierung (C).

8. Monolithisches Halbleiterbauteil zur Realisierung der Schaltung nach Anspruch 6, mit einem Thyristor nach Anspruch 7,
dadurch gekennzeichnet, daß das Bauteil des weiteren in den zweiten Bereichen (34, 34') mit einer fünften Metallisierung (D) verbundene sechste Bereiche (38, 38') umfaßt.

## Claims

1. A circuit comprising a thyristor controllable by logic signals referenced to the ground, independently of its cathode voltage, characterized in that it comprises:
a thyristor (Th) ;
a PNP transistor connected between the cathode gate and the anode of the thyristor; and
an NPN transistor between the base of the PNP transistor and a terminal connected to ground through a resistor, the base of the NPN transistor receiving said logic signals.

2. A switching circuit for charging batteries, disposed at the secondary of a transformer (1) to charge a battery (3) according to conditions set by a switching control integrated circuit (5), characterized in that it comprises:
a thyristor (Th) according to claim 1; and
rectifying diodes (D1, D2) connected between the terminals of the secondary of the transformer and the anode of the thyristor.

3. The switching circuit of claim 2, further comprising a terminal adapted to feed a circuit (4) providing a regulated voltage, characterized in that it further comprises a diode (D3) connected between the common node of the first and second diodes and said terminal.

4. The thyristor of claim 1, characterized in that it comprises in a low doped substrate (11) of a first conductivity type:
- a well-type thyristor comprising:
. on the rear surface of the substrate, a first region (12) of the second conductivity type, an isolation wall (13) of the second conductivity type extending from the upper surface of the substrate to the periphery of the first region (12),
. on the upper surface of the substrate, a second region (14) of the second conductivity type and a third region (15) of the first conductivity type that is formed in the third region;
- in a portion of the substrate region (21), delineated by the isolation wall, a fourth region (22) of the second conductivity type and, in said fourth region, a fifth region (23) of the first conductivity type,
- first, second, third, and fourth metallizations (M2, C, E, G) contacting the rear surface of the substrate, the third region, the fourth region and the fifth region, respectively.

5. A monolithic semiconductor component for implementing the circuit of claim 2, comprising a thyristor according to claim 4, characterized in that it further comprises, outside the region delineated by the isolation wall:
a first vertical diode (D1) formed between a fifth metallization (A) contacting a sixth region (25) of the second conductivity type and the first metallization (M2),
a second vertical diode (D2) formed between a sixth metallization (B) contacting a seventh region (26) of the second conductivity type and the first metallization (M2),
a third lateral diode (D3) formed between a seventh metallization (M1), contacting an eighth region (27) of the second conductivity type and the substrate (11), and an eighth metallization (D) contacting a ninth region (28) of the first conductivity type formed in the eighth region (27).

6. A switching circuit disposed at the secondary of a transformer (1) for charging batteries according to conditions fixed by a switching control integrated circuit (5), characterized in that it comprises:
a first and second thyristor (Th) according to claim 1, between each transformer terminal and a battery supply terminal,
rectifying diodes (D6, D7) between each transformer terminal and a common supply terminal (D).

7. The monolithic thyristor of claim 1, characterized in that it comprises, in a low doped substrate (31) of a first conductivity type:
a first layer (32) of the second conductivity type, on the rear surface of the substrate,
an isolation wall (33) of the second conductivity type extending from the upper surface of the substrate at the periphery of the first layer (32),
on the upper surface of the substrate, second regions (34, 34') and third regions (35, 35') of the second conductivity type,
fourth regions (36, 36') of the first conductivity type formed in the third regions,
a fifth region (37) of the second conductivity type formed on the rear surface of the substrate,
first metallizations (A, B) contacting each second region,
a second metallization (E) contacting the third regions,
a third metallization (G) contacting the fourth regions, and
a fourth metallization (C) contacting the rear surface.

8. A monolithic semiconductor component for implementing the circuit of claim 6, comprising a thyristor according to claim 7, characterized in that it further comprises, in the second regions (34, 34'), sixth regions (38, 38') contacting a fifth metallization (D).
